Europäisches Patentamt

European Patent Office

Office européen des brevets

(11) Publication number: **0 453 961 A2**

# EUROPEAN PATENT APPLICATION

(21) Application number: 91106223.0

(22) Date of filing: 18.04.91

(51) Int. Cl.5: **H01L 27/11**

(30) Priority: 20.04.90 JP 104578/90

(43) Date of publication of application:
30.10.91 Bulletin 91/44

(84) Designated Contracting States:
DE FR GB

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Kobayashi, Kiyoshi, c/o Intellectual**
**Property Div.**
**Kabushiki Kaisha Toshiba, 1-1 Shibaura**
**1-chome**
**Minato-ku, Tokyo 105(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) **SRAM using E/R memory cells that help decrease the software error rate.**

(57) In an E/R static semiconductor memory device containing memory cells composed of driving MOS transistors and high load resistors, according to this invention, there is a contact diffusion region (16-1, 16-2, 16-3) of a second conductivity type, which is formed so as to extend to the drain region (15) of the MOS transistor formed in the semiconductor body (12), and whose diffusion depth is deeper than those of the source and drain regions of the MOS transistor. In addition, directly below the contact diffusion region (16-1, 16-2, 16-3) in the semiconductor body is a potential barrier diffusion region (24) of a first conductivity type, whose impurity atom concentration is higher than that of the semiconductor body (12).

F I G. 2A

F I G. 2B

EP 0 453 961 A2

This invention relates to a static RAM using E/R memory cells, and more particularly to improvements in the software error rate for static RAMs having a deep contact diffusion layer.

There are two main types of memory cells of static RAMs (hereinafter, referred to as SRAMs): the 6-transistor cell, which is composed mainly of 6 transistors, and the E/R cell, which is made up chiefly of 4 transistors and 2 resistors. For SRAMs with a large capacity more than 64K bits, E/R cells are mostly used because they help minimize the cell area.

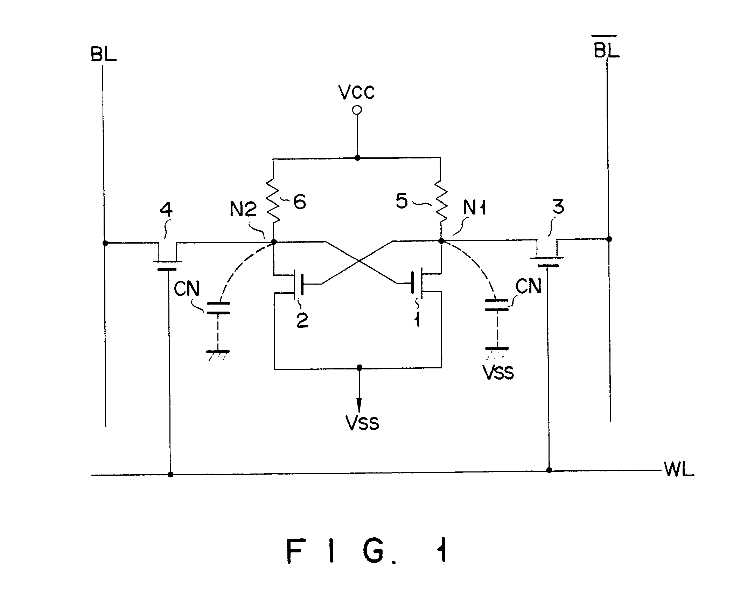

Fig. 1 is a circuit diagram of a conventional E/R memory cell (or E/R cell). Two MOS transistors 1 and 2 have their gates connected to each other's drains (or cell nodes) and both their sources connected to the ground voltage $V_{SS}$. MOS transistors 3 and 4 are transfer transistors that connect the cell nodes N1 and N2 with bit lines $\overline{BL}$ and BL, respectively, and both their gates connected to word line WL. Load resistors 5 and 6 for the MOS transistors 1 and 2 are inserted between the supply voltage $V_{CC}$ and the cell nodes N1 and N2, respectively.

To integrate E/R cells of this arrangement into a semiconductor chip, buried contacts or shared contacts having deep contact diffusion layers are often used in portions where the cell nodes N1 and N2 contact with a conductor layer on the substrate. These contacts make a great contribution to a reduction in the size of the drain diffusion region and polysilicon layer in the drain contact portion of each of the MOS transistors connected to the cell nodes N1 and H2. This further improves the minimization of the cell area, a main feature of E/R memory cells.

However, E/R cells are inferior to 6-transistor cells in the stability because the resistors 5 and 6 are used as loads for the MOS transistors 1 and 2 in place of active elements. To improve the stability, attempts have been made by replacing the resistors with loads $T_R$ composed of p-channel MOS transistors such as TFTs (thin film transistors), but a problem is that the on current through the active elements is as small as several nanoamperes (nA). This will be explained in more detail.

In any type of memory cells using the above-mentioned buried contact or shared contact, as their size has become smaller, the capacity $C_N$ of the cell nodes N1 and N2 has decreased accordingly. For instance, the capacity $C_N$ in the E/R cell on the 1 $\mu$m rule is as small as nearly 10 fF. To achieve low power consumption, the load resistors 5 and 6 are as high as several ten $G\Omega$ to several $T\Omega$. The time constant $\tau$ for charging the capacity $C_N$ via these resistors is as long as several hundred $\mu$sec to several ten msec. (Incidentally, use of the TFT provides an on resistance of several $M\Omega$ and a time constant $\tau$ of several $\mu$sec.)

Such an arrangement is liable to cause software errors due to $\alpha$ rays. For example, with the cell node N1 at the 1 level, when $\alpha$ rays are thrown in the vicinity of the node N1, electron-hole pairs will appear. Electrons, the minority carriers, are caught by the cell node N1, discharging the capacity $C_N$ instantaneously. Particularly, such a movement of electrons takes place at a speed as fast as several ten psec in the funneling process in which they go across the junction of diffused layers.

After the discharge of the capacity $C_N$ due to incident a rays, the time required to restore the cell node N1 to its original level by charging its capacity $C_N$ viathe high load resistor 5 is as long as several hundred $\mu$sec to several ten msec. In the meantime, with the incidence of $\alpha$ rays, the cell node N1 changes from the 1 to the 0 level, which once causes the transistor 2 to turn off, thereby causing the cell node N2 together with the cell node N1 to change from the 0 to the 1 level. During the action, if there is a read operation taking place, the wrong data will be read out. Additionally, the difference in the returning characteristic to the 1 level between cell nodes N1 and N2 will destroy the memory cell data, resulting in erroneous operations. Thus, E/R cells have the drawback of software errors being liable to occur in the existence of $\alpha$ rays. For example, DRAMs require a memory cell with a capacity of nearly 30 fF to make the amount of cell-retained charge larger than the amount of charge entering the cell node due to incident a rays. Compared to this, E/R cells have a memory cell capacity of nearly 10 fF, which is obviously smaller than the amount of charge entering the cell node owing to $\alpha$ rays. There are two software error measures for E/R cells: first, to increase the capacity of the cell node, and second, to decrease the accumulated amount of charge due to incident $\alpha$ rays. However, the first measure makes the integration more difficult.

Accordingly, the object of the present invention is to provide a static semiconductor memory device using E/R memory cells that help reduce achieve the accumulated amount of charge due to $\alpha$ rays in connection with the second measure described above.

The object of the invention is accomplished by an E/R static semiconductor memory device containing memory cells composed of driving MOS transistors and high load resistors, comprising: a semiconductor body of a first conductivity type; the source and drain regions of a second conductivity type of the MOS transistor formed in the semiconductor body; a contact diffusion region of the second conductivity type, which is formed in the semiconductor body so as to extend to the drain region, and whose diffusion depth is deeper than those of the source and drain regions; a potential barrier diffusion region of the first conductivity, which is formed directly below the contact diffusion region in the semiconductor body, and whose impurity concentration is higher than the semiconductor body; and a conductor layer one end of which is connected to the contact diffusion region and part of which acts as a high load resistor.

In this configuration, there is a potential barrier diffusion region directly below the deep contact diffusion region susceptible to the carrier movement due to incident α rays, whose conductivity type is opposite to that of the contact diffusion region. Thus, α ray-caused electrons are prevented from entering the contact diffusion region.

This invention can be more fully understood from the following detailed description when taken in conjunction with the accompanying drawings, in which:

Fig. 1 is an equivalent circuit of a conventional E/R static memory cell;

Fig. 2A is a plan view for a pattern of an E/R cell according to an embodiment of the present invention;

Fig. 2B is a sectional view taken along line 2B-2B of Fig. 2A;

Fig. 3 is a characteristic diagram showing software error rates for the E/R static memory to compare the effects of the deep contact diffusion layer;

Fig. 4 is a sectional view illustrating the effects of incident a rays on the cell node;

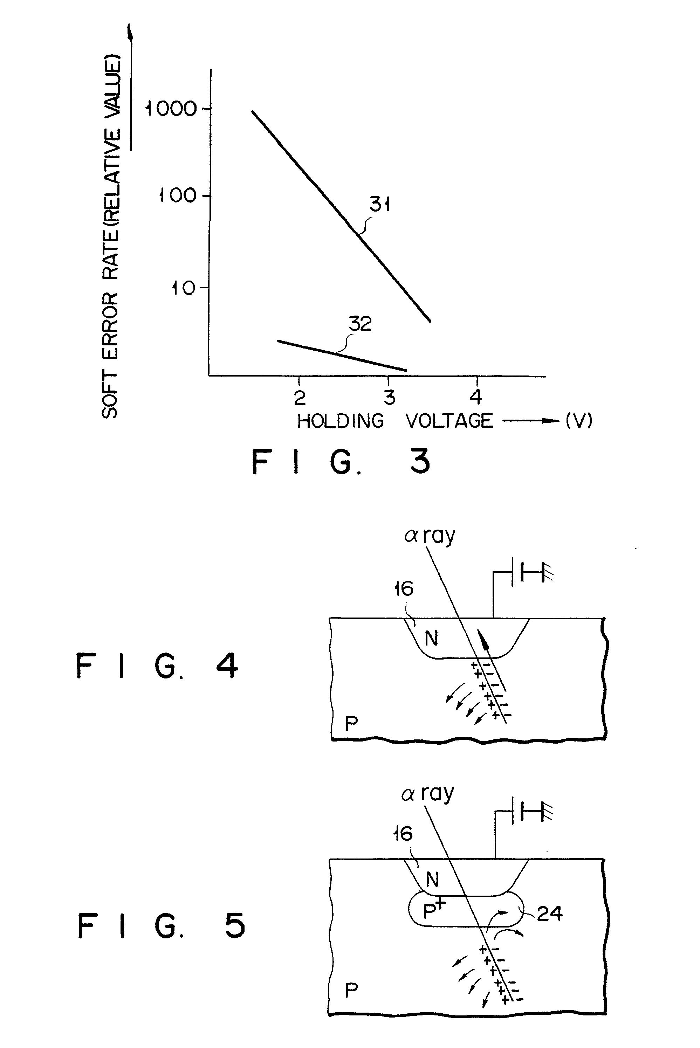

Fig. 5 is a sectional view showing the effects of the potential barrier diffusion region;

Figs. 6A through 6C are sectional views sequentially illustrating the manufacturing processes of the E/R static memory of Fig. 2B;

Fig. 7A is a plan view for a pattern of an E/R cell according to another embodiment of the present invention;

Fig. 7B is a sectional view taken along line 7B-7B of Fig. 7A;

Figs. 8A and 8B are sectional views sequentially illustrating the manufacturing processes of the E/R static memory of Fig. 7B;

Fig. 9 is a sectional view for a first application according to the embodiment of Fig. 2B;

Fig. 10 is a sectional view for a second application according to the embodiment of Fig. 2B;

Fig. 11 is a sectional view for a third application according to the embodiment of Fig. 2B;

Fig. 12 is a sectional view for a fourth application according to the embodiment of Fig. 2B; and

Fig. 13 is a sectional view for an application according to the embodiment of Fig. 7B.

The present invention will be explained, referring to the accompanying drawings.

Fig. 2A is a plan view of an E/R cell using buried contact according to an embodiment of the present invention. Fig. 2B is a sectional view taken along line 2B-2B of Fig. 2A. Like parts in Fig. 2A and Fig. 2B are indicated by like reference characters. The same holds true for Fig. 2A and Fig. 1.

On an n-type semiconductor substrate 11, a p-type well region 12 is formed. At a surface of the well region 12 encircled by an element-isolating insulating film 13, the diffusion region 14, 15 of a transfer transistor 4 acting as the source or drain on the cell node N2 side of Fig. 1 are formed. A contact diffusion region 16-1, designed to form a buried contact extending to the diffusion region 15, is formed to a thickness of 0.4 to 0.6 μm, deeper than the diffusion region 15. Formed on the well region 12 is a gate oxide film 17, on which a gate electrode 18 is formed so as to cross the diffusion regions 14 and 15, completing the MOS transistor shown in Fig. 1.

On the contact diffusion region 16-1, a first polysilicon layer 19 is formed which serves as the gate electrode of one n-channel MOS transistor 1 constituting the flip flop. On the first polysilicon layer 19, a second polysilicon layer 21 is formed via an interlayer insulating film 20. The second polysilicon layer 21 is connected via a contact hole 22 in the interlayer insulating film 20 to the first polysilicon layer 19.

In Fig. 2A, the second polysilicon layer 21 is represented by a broken line. The load resistor 5 and 6 of Fig. 1 are made up of part of the second polysilicon layer 21. This layer 21 is also connected to another contact hole 23. To connect the first polysilicon layer 19 with the cell node N1 (shown in Fig. 1), a deep contact diffusion region 16-2 is formed as shown in Fig. 2B, to provide a buried contact. With the contact hole 23, the n-channel MOS transistor 3 serving as the cell node N1-side transfer gate, the drain of the MOS transistor 1, and the gate electrode (the first polysilicon layer 19) of the other n-channel MOS transistor 2 constituting the flip flop are connected one another.

To connect the drain of the MOS transistor 2 with the cell node N2, the first polysilicon layer 19 acting as the gate of the transistor 1 is extended. This portion also have a buried contact composed of a deep contact diffusion region 16-3 as described above.

Fig. 2A shows deep contact diffusion regions 16 for buried contacts by shaded portions: one region (16-2) on the cell node N1 side and two regions (16-1, 16-3) on the cell node N2 side.

With incident α rays, electron-hole pairs appear in the well region below the contact diffusion regions 16, causing the carriers to easily move to the diffusion regions 16. This results in a change in the potential state of the contact diffusion regions 16, causing software errors.

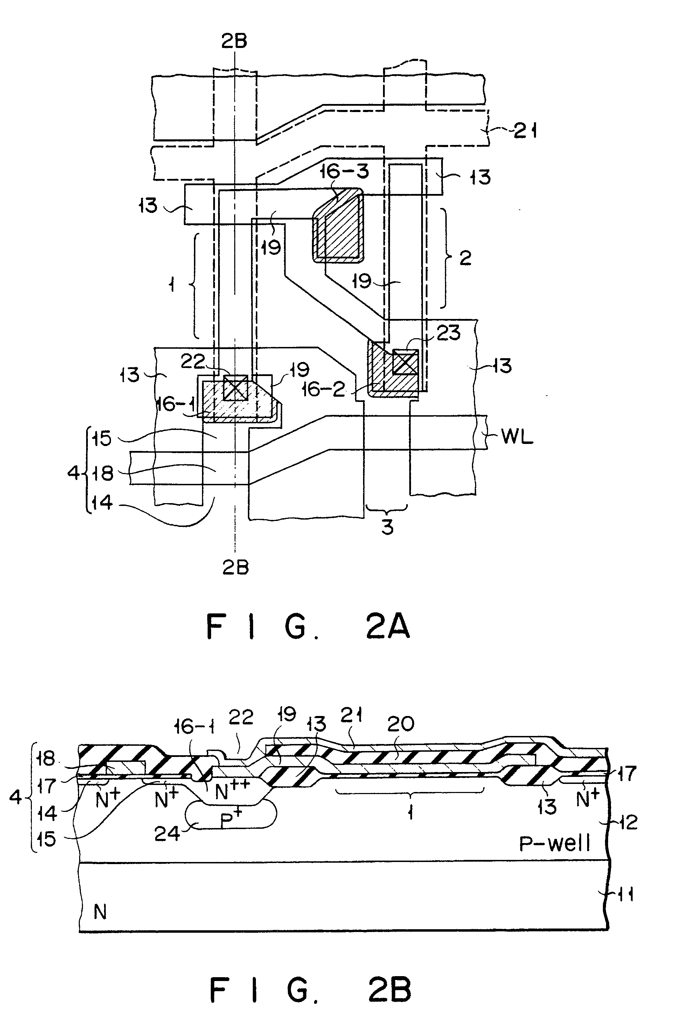

Fig. 3 is a characteristic diagram showing the results of a test for software errors in an E/R cell having buried contacts. A solid line 31 indicates the software error rate when a 1 was retained on the cell node N2 side containing two buried contacts and a 0 on the cell node N1 side containing a single buried contact, whereas a solid line 32 represents the software error rate when a 0 was hold on the cell N2 side and $a_1$ on the cell node N1 side. The software error rate on the cell node N2 side is remarkably larger than that on the cell node N1 side, which makes it obvious that incident $\alpha$ rays tend to cause carriers to enter the deep contact diffusion regions 16.

In the embodiment of this invention, as shown in Fig. 2A, a $p^+$-type potential barrier diffusion region 24, whose p-type impurity (e.g., boron) concentration is higher than that of the well region 12, is formed directly below and in contact with the diffusion region 16 for a buried contact.

With the potential of the contact diffusion region 16 being high, if the potential barrier diffusion region 24 does not exist, the holes of a ray-caused electron-hole pairs easily escape to the substrate, while the electrons easily enter the diffusion region 16 as shown in Fig. 4, making the region's potential lower. When the potential barrier diffusion region 24 exists as with the arrangement of Fig. 2A, although the holes of a ray-caused electron-hole pairs escape to the substrate, the electrons cannot cross the potential barrier 24 to reach the diffusion region 16.

Thus, the potential barrier 24 acts on the minority carriers (the electrons caused by $\alpha$ rays) to suppress the carrier movement to the cell nodes N1 and N2, thereby preventing software errors due to $\alpha$ rays.

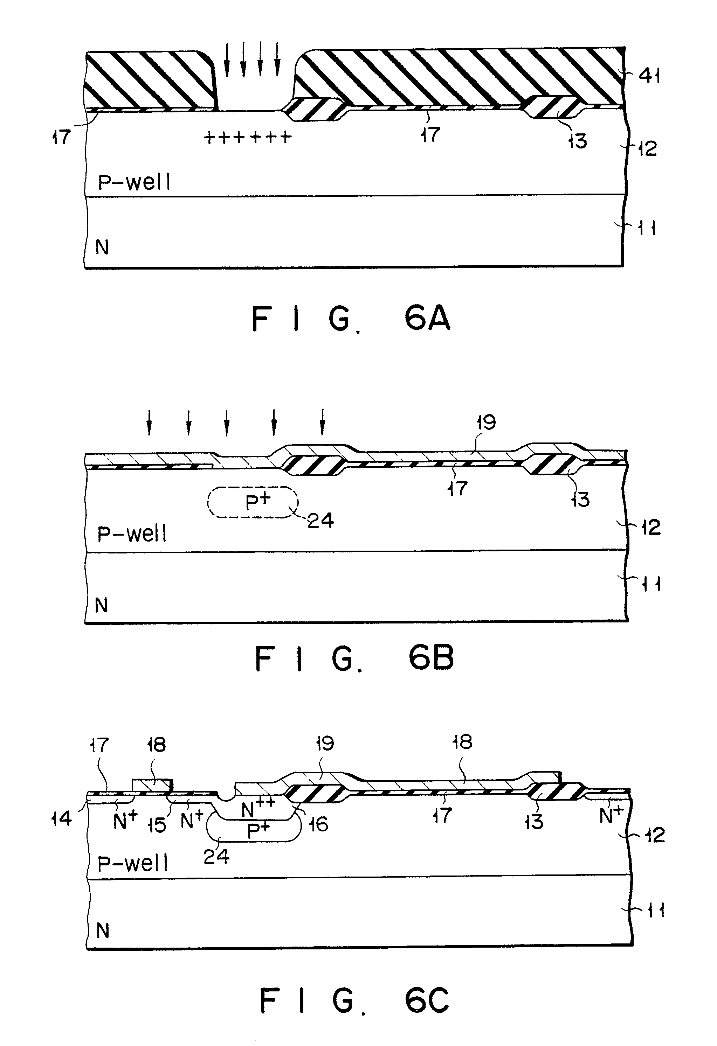

Figs. 6A through 6C are sectional views sequentially illustrating the manufacturing processes of a semiconductor static memory device according to the embodiment. After an element-isolating insulating film 13 is formed at a p-type well region 12 over an n-type semiconductor substrate 11, a gate oxide film 17 is formed. The surface is then covered with a photoresist 41 to selectively etch the gate oxide film 17 on the element-isolating insulating film 13 to expose the surface of the well region 12. The exposed region is where the contact diffusion region 16 is to be made. Then, boron ions are implanted into the exposed surface of the well region 12 at a rate of nearly $10^{13}$ cm$^{-2}$. The implantation depth is preferably such that the impurity atom concentration peak may appear at a place as deep as or deeper than the contact diffusion region formed later (Fig. 6A).

After removal of the photoresist 41, a first polysilicon layer 19 serving as a gate electrode is deposited to a suitable thickness over the entire surface including the top surface of the well region 12 in which the potential barrier 24 is formed. An n-type dopant is then added to the first polysilicon layer 19 (Fig. 6B).

During this process, the n-type dopant is diffused into the well region 12 via the buried contact region where the gate oxide film 17 has been removed, with the result that a 0.4 to 0.6 $\mu$m-deep diffusion region 16 is formed. The first polysilicon layer 19 is then patterned to form the gate electrode 18 of each transistor. After this, the $n^+$-type source and drain regions 14 and 15 are formed (Fig. 6C).

Then, as shown in Fig. 2B, an interlayer insulating film 20 and a second polysilicon layer 21 are deposited in that order. Now, a memory cell is completed which has a buried contact with the potential barrier 24 directly below the contact diffusion region (16-1, 16-2, 16-3).

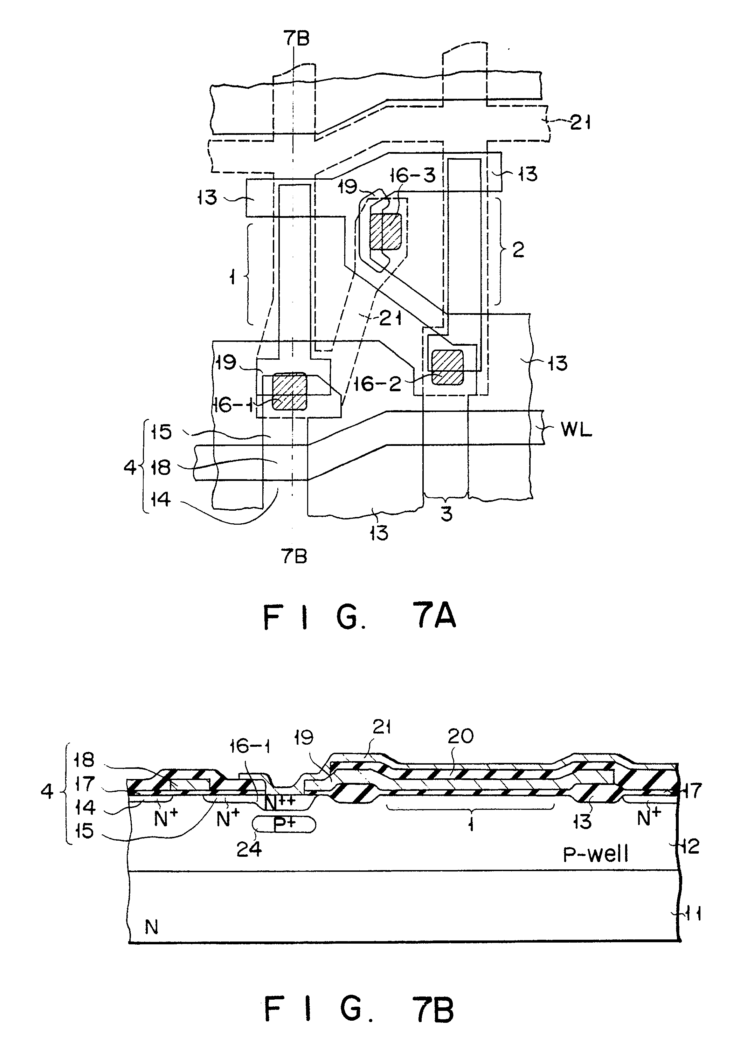

Fig. 7A is a plan view for a pattern of an E/R cell using shared contacts according to another embodiment of the present invention. Fig. 7B is a sectional view taken on line 7B-7B of Fig. 7A. Like parts in Figs. 7A and 7B, Fig. 1, and Figs. 2A and 2B are indicated by like reference characters and their explanation will be omitted.

While in the embodiment of Fig. 2A using buried contacts, the contact diffusion region 16 is directly connected to the first polysilicon layer 19, in the embodiment of Fig. 7A using shared contacts, the second polysilicon layer 21 (indicated by a broken line) is directly connected to the contact diffusion region 16. Thus, the second polysilicon layer 21 is extended from the contact diffusion region 16-1 so as to connect the drain of the MOS transistor 2 constituting a flip flop to the cell node N2, while the contact diffusion region 16-3 connects the gate of the transistor 1 to the drain of the transistor 2.

As with the previous embodiment, in a memory cell according to this embodiment, a $p^+$-type potential barrier 24, whose p-type impurity concentration is high, is formed directly below the deep $n^{++}$-type contact diffusion region for a shared contact. This barrier acts on the minority carriers.

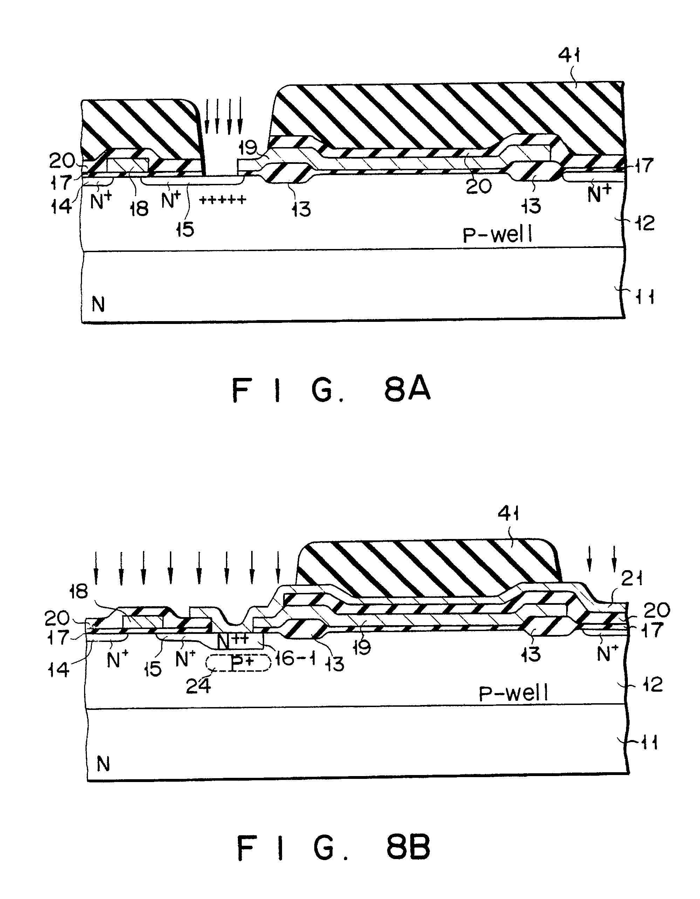

Figs. 8A and 8B are sectional views sequentially illustrating the manufacturing processes of the E/R cell of Fig. 7B. At a p-type well region 12 on an n-type semiconductor substrate 11, an element-isolating insulating film 13, a gate oxide film 17, a first polysilicon layer 19 are formed in sequence. The first polysilicon layer 19 is patterned to form a gate electrode 18. After $n^+$-type source and drain regions 14 and 15 are formed, an interlayer insulating film 20 is deposited. Then, a photoresist 31 is formed, followed by the etching of the insulating film 20 by a suitable method such as the RIE technique to form an opening for a shared contact.

Into the surface of the well region 12 exposed through the opening, boron ions are implanted at a rate of nearly $10^{13}$ cm$^{-2}$ to form a contact diffusion region 16 to a depth of 0.4 to 0.6 $\mu$m (Fig. 8A).

Then, a second polysilicon layer 21 is deposited and patterned. After the patterning, an n-type dopant (e.g., phosphorous, P) is introduced into a portion of interconnection regions including part of the shared contact by ion implantation. At this time, the n-type impurity is introduced into the p-type well region 12 via the shared contact, which forms a deep $n^{++}$-type diffusion region. The diffusion depth Xj of the $n^{++}$-type diffusion layer is 0.3 to 0.5 $\mu$m, while the previously implanted p-type potential barrier diffusion region 24 is formed so as to have the impurity concentration peak at a place deeper than or as deep as those figures (Fig. 8).

With devices and methods according to the above embodiments, it is hard for a ray-caused minority carriers to move to a portion having a deep diffusion layer, such as a buried contact or a shared contact, for connecting E/R cell circuits, which reduces software errors in E/R SRAMs. Since both embodiments can form a buried contact or a shared contact as well as a potential barrier by ion implantation, it is not necessary to add another photoetching process.

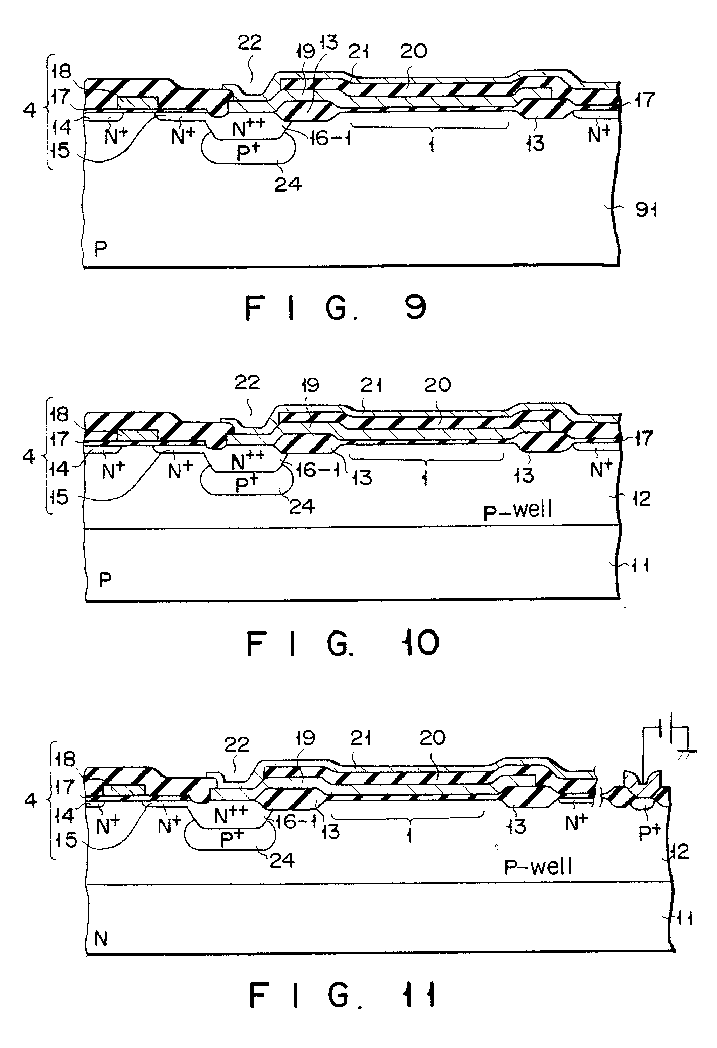

Although in the above embodiments, a p-type well region on an n-type substrate is used as a semiconductor substrate on which elements are formed, a p-type semiconductor substrate or a p-type well region on a p-type semiconductor substrate may used for the same arrangement. Taking Fig. 2B as an example, embodiments using the configurations just mentioned are shown in Figs. 9 and 10. The same holds true for Fig. 7B, which is not shown.

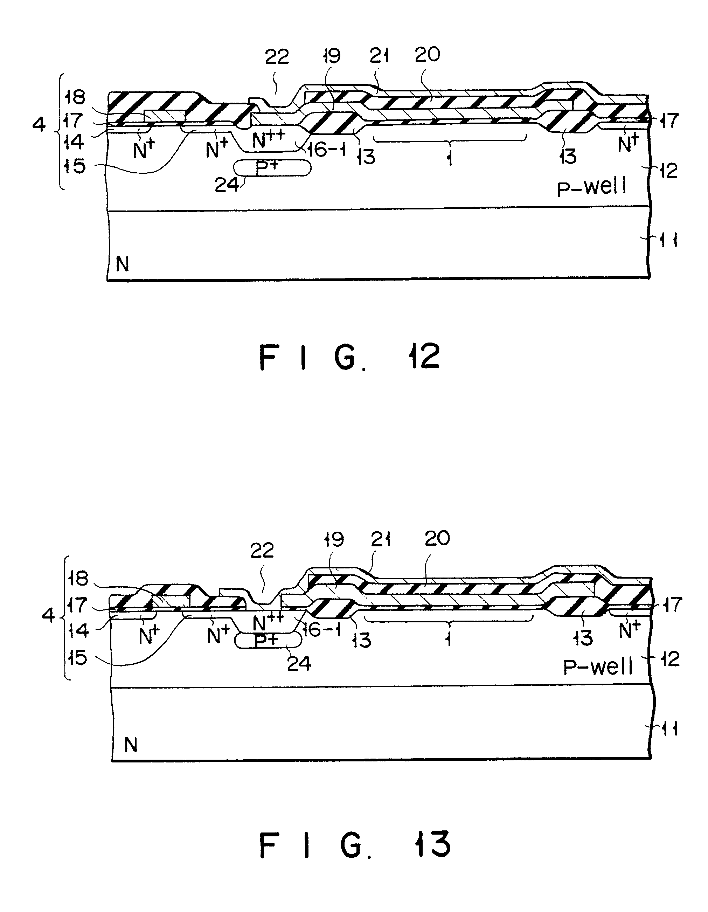

In Fig. 11 taking Fig. 2B as an example, even if the semiconductor substrate constituting elements is biased to a voltage other than the GND such as a voltage lower than the GND, the potential barrier 24 still has great effects. The same holds true for Fig. 7B.

While in Fig. 2B, the potential barrier diffusion region 24 is formed in contact with the deep contact diffusion region 16, the barrier 24 may be formed out of contact with the region 16 as shown in Fig. 12. Although in Fig. 7B, the potential barrier 24 is formed apart from the contact diffusion region 16, the barrier 24 may be formed in touch with the region 16. The point is that the potential barrier 24 is formed directly below the contact diffusion region 16.

If a $p^+$-type region were additionally formed in a place other than directly below the contact diffusion region 16, the $p^+$-type region would appear below the drain or gate of each transistor in the well region. Consequently, this would degrade the driving characteristics of MOS transistors constituting the cell.

The potential barrier diffusion region should be formed in such a way not to degrade the driving characteristic of the memory cells and that of the MOS transistors which are not components of the memory cells, and not to increase the junction capacitance of these MOS transistors. Thus, it is important to form the potential barrier diffusion region 24, whose $p^+$-type impurity concentration is higher than that of the p-type well, in a minimum area, or directly below an $n^{++}$-type contact diffusion region only.

As described above, this invention provides a semiconductor static memory device using E/R memory cells that suppress incident $\alpha$ ray-caused software errors by forming a potential barrier directly below a deep contact diffusion region.

Reference signs in the claims are intended for better understanding and shall not limit the scope.

## Claims

1. An E/R static semiconductor memory device containing memory cells composed of driving MOS transistors and high load resistors, characterized by comprising:

   a semiconductor body (12) of a first conductivity type;

   the source region (14) and drain region (15) of a second conductivity type of said MOS transistor formed in said semiconductor body (12);

   a contact diffusion region (16-1, 16-2, 16-3) of the second conductivity type which is formed in said semiconductor body (12) so as to extend to said drain region (15), and the diffusion depth of which is deeper than those of said source and drain regions;

   a potential barrier diffusion region (24) of the first conductivity type, which is formed directly below said contact diffusion region (16-1, 16-2, 16-3) in said semiconductor body (12), and whose impurity atom concentration is higher than that of said semiconductor body; and

   a conductor layer (21) one end of which is connected to said contact diffusion region (16-1, 16-2, 16-3) and the other end of which is connected to said high load resistor.

2. A semiconductor memory device according to claim 1, characterized in that said conductor layer (21) functions as said high load resistor.

3. A semiconductor memory device according to claim 1, characterized in that said semiconductor body (12) of the first conductivity type is a p-type silicon substrate biased to the ground.

4. A semiconductor memory device according to claim 1, characterized in that said semiconductor body (12) of the first conductivity type is a p-type silicon substrate biased to a voltage lower than the ground.

5. A semiconductor memory device according to claim 1, characterized in that said semiconductor body (12) of the first conductivity type is a p-type well region formed on a p-type silicon substrate, biased to the ground.

6. A semiconductor memory device according to claim 1, characterized in that said semiconductor body (12) of the first conductivity type is a p-type well region formed on a p-type silicon substrate, biased to a voltage lower than the ground.

7. A semiconductor memory device according to claim 1, characterized in that said semiconductor body (12) of the first conductivity type is a p-type well region formed on an n-type silicon substrate, biased to the ground.

8. A semiconductor memory device according to claim 1, characterized in that said semiconductor body (12) of the first conductivity type is a p-type well region formed on an n-type silicon substrate, biased to a voltage lower than the ground.

9. A semiconductor memory device according to claim 1, characterized in that said potential barrier diffusion region (24) directly below said contact diffusion region (16-1, 16-2, 16-3) is formed in contact with said contact diffusion region.

10. A semiconductor memory device according to claim 1, characterized in that said potential barrier diffusion region (24) directly below said contact diffusion region (16-1, 16-2, 16-3) is formed so as to have the peak of the impurity atom concentration at a place nearly as deep as said contact diffusion region.

11. A semiconductor memory device according to claim 1, characterized in that said potential barrier diffusion region (24) directly below said contact diffusion region (16-1, 16-2, 16-3) is formed out of contact with said contact diffusion region.

12. A semiconductor memory device according to claim 1, characterized in that one end of said conductor layer (21) is indirectly connected to the surface of said contact diffusion region (16-1, 16-2, 16-3).

13. An E/R static semiconductor memory device containing memory cells composed of driving MOS transistors and high load resistors, characterized by comprising:

a semiconductor body (12) of a first conductivity type;

the source region (14) and drain region (15) of a second conductivity type of said MOS transistor formed in said semiconductor body (12);

a contact diffusion region (16-1, 16-2, 16-3) of the second conductivity type which is formed in said semiconductor body (12) so as to extend to said drain region (15), and the diffusion depth of which is deeper than those of said source and drain regions;

a potential barrier diffusion region (24) of the first conductivity type, which is formed directly below said contact diffusion region (16-1, 16-2, 16-3) in said semiconductor body (12), and whose impurity atom concentration is higher than that of said semiconductor body;

a first polysilicon layer (19) at least one end of which is connected to said contact diffusion region (16-1, 16-2, 16-3), and part of which forms the gate of said MOS transistor; and

a second polysilicon layer (21) one end of which is connected to the first polysilicon layer at the top of said contact diffusion region (16-1, 16-2, 16-3), and the other end of which is connected to said high load resistor.

14. A semiconductor memory device according to claim 13, characterized in that said second polysilicon layer (21) functions as said high load resistor.

15. A semiconductor memory device according to claim 13, characterized in that said semiconductor body (12) of the first conductivity type is a p-type silicon substrate biased to the ground.

16. A semiconductor memory device according to claim 13, characterized in that said semiconductor body (12) of the first conductivity type is a p-type silicon substrate biased to a voltage lower than the ground.

17. A semiconductor memory device according to claim 13, characterized in that said semiconductor body (12) of the first conductivity type is a p-type well region formed on a p-type silicon substrate, biased to the ground.

18. A semiconductor memory device according to claim 13, characterized in that said semiconductor body (12) of the first conductivity type is a p-type well region formed on a p-type silicon substrate, biased to a voltage lower than the ground.

19. A semiconductor memory device according to claim 13, characterized in that said semiconductor body (12) of the first conductivity type is a p-type well region formed on an n-type silicon substrate, biased to the ground.

20. A semiconductor memory device according to claim 13, characterized in that said semiconductor body (12) of the first conductivity type is a p-type well region formed on an n-type silicon substrate, biased to a voltage lower than the ground.

21. A semiconductor memory device according to claim 13, characterized in that said potential barrier diffusion region (24) formed directly below said contact diffusion region (16-1, 16-2, 16-3) is formed in contact with said contact diffusion region.

22. A semiconductor memory device according to claim 13, characterized in that said potential barrier diffusion region (24) formed directly below said contact diffusion region (16-1, 16-2, 16-3) is formed so as to have the peak of the impurity atom concentration at a place nearly as deep as said contact diffusion region.

23. A semiconductor memory device according to claim 13, characterized in that said potential barrier diffusion region (24) only formed directly below said contact diffusion region (16-1, 16-2, 16-3) is formed out of contact with said contact diffusion region.

24. An E/R static semiconductor memory device containing memory cells composed of driving MOS transistors and high load resistors, characterized by comprising:
   a semiconductor body (12) of a first conductivity type;
   the source region (14) and drain region (15) of a second conductivity type of said MOS transistor formed in said semiconductor body (12);
   a contact diffusion region (16-1, 16-2, 16-3) of the second conductivity type which is formed in said semiconductor body (12) so as to extend to said drain region (15), and the diffusion depth of which is deeper than those of said source and drain regions;
   a potential barrier diffusion region (24) of the first conductivity type, which is formed directly below said contact diffusion region (16-1, 16-2, 16-3) in said semiconductor body (12), and whose impurity atom concentration is higher than that of said semiconductor body;
   a first polysilicon layer (19) formed on an insulating film over said semiconductor body (12), part of which forms the gate of said MOS transistor; and
   a second polysilicon layer (21) one end of which is connected to said contact diffusion region (16-1, 16-2, 16-3) and said first polysilicon layer, and the other end of which is connected to said high load resistor.

25. A semiconductor memory device according to claim 24, characterized in that said second polysilicon layer (21) functions as said high load resistor.

26. A semiconductor memory device according to claim 24, characterized in that said semiconductor body (12) of the first conductivity type is a p-type silicon substrate biased to the ground.

27. A semiconductor memory device according to claim 24, characterized in that said semiconductor body (12) of the first conductivity type is a p-type silicon substrate biased to a voltage lower than the ground.

28. A semiconductor memory device according to claim 24, characterized in that said semiconductor body (12) of the first conductivity type is a p-type well region formed on a p-type silicon substrate, biased to the ground.

29. A semiconductor memory device according to claim 24, characterized in that said semiconductor body (12) of the first conductivity type is a p-type well region formed on a p-type silicon substrate, biased to a voltage lower than the ground.

30. A semiconductor memory device according to claim 24, characterized in that said semiconductor body (12) of the first conductivity type is a p-type well region formed on an n-type silicon substrate, biased to the ground.

31. A semiconductor memory device according to claim 24, characterized in that said semiconductor body (12) of the first conductivity type is a p-type well region formed on an n-type silicon substrate, biased to a voltage lower than the ground.

32. A semiconductor memory device according to claim 24, characterized in that said potential barrier diffusion region (24) formed directly below said contact diffusion region is formed in contact with said contact diffusion region (16-1, 16-2, 16-3).

33. A semiconductor memory device according to claim 24, characterized in that said potential barrier diffusion region (24) formed directly below said contact diffusion region (16-1, 16-2, 16-3) is formed so as to have the peak of the impurity atom concentration at a place nearly as deep as said contact diffusion region.

34. A semiconductor memory device according to claim 24, characterized in that said potential barrier diffusion region (24) formed directly below said contact diffusion region (16-1, 16-2, 16-3) is formed out of contact with said contact diffusion region.

F I G. 1

F I G. 2A

F I G. 2B

F I G. 3

F I G. 4

F I G. 5

F I G. 6A

F I G. 6B

F I G. 6C

F I G. 7A

F I G. 7B

F I G. 8A

F I G. 8B

F I G. 9

F I G. 10

F I G. 11

F I G. 12

F I G. 13